# FASCICULE DE BREVET EUROPEEN

(11) **EP 0 452 222 B1**
(45) Date de publication et mention de la délivrance du brevet: **08.01.1997**
(21) Numéro de dépôt: 91400977.4
(22) Date de dépôt: 11.04.1991
(51) Int. Cl.: H01L 21/00, H02N 13/00

(54) **Porte-substrat électrostatique**
Elektrostatischer Substrathalter
Electrostatic substrat holder

(30) Priorité: 12.04.1990 FR 9004728
(43) Date de publication de la demande: 16.10.1991
(73) Titulaire: COMMISSARIAT A L'ENERGIE ATOMIQUE, 75015 Paris (FR)
(72) Inventeur: Daviet, Jean-François, F-74000 Cran-Gevrier (FR); Jeuch, Pierre, F-38180 Seyssins (FR); Peccoud, Louise, F-38640 Claix (FR); Renard, Pierre, F-38000 Grenoble (FR)
(74) Mandataire: Ilgart, Jean-Christophe

(56) Documents cités:
- EP-A- 0 049 588
- EP-A- 0 138 254
- EP-A- 0 171 011
- EP-A- 0 260 150
- PATENT ABSTRACTS OF JAPAN vol. 10, no. 133 (E-404)(2190) 17 mai 1986,
- & JP-A- 60 261377 (NIPPON DENSHIN DENWA KOSHA) 24 décembre 1985,

## Description

La présente invention a trait à un porte-substrat électrostatique.

Les substrats en forme de disques ou de plaquettes doivent souvent être maintenus en place en vue de les soumettre à divers traitements dans l'industrie de l'électronique. Les systèmes les plus intéressants connus à ce jour comprennent un porte-substrat en matériau isolant sur une surface supérieure duquel le substrat est posé et dans lequel sont incluses deux électrodes situées dans un même plan parallèle au substrat, qui sont portées à des potentiels différents et dont la surface totale correspond sensiblement à la surface du substrat, si on excepte les espaces isolants séparant les électrodes. Le substrat est maintenu par les forces électrostatiques produites par les électrodes.

Dans un système connu, un substrat circulaire est maintenu par deux électrodes en forme de demi-lunes dont les côtés plans sont séparés par un intervalle correspondant à un diamètre du substrat. Dans un second système, les électrodes sont en forme de peignes dont les arêtes sont recourbées ; chacune s'étend sensiblement sur un demi-périmètre du substrat, tandis que les dents s'étendent, mutuellement imbriquées, selon des directions parallèles sous le substrat jusque près de l'arête de l'autre peigne. Des exemples peuvent en être trouvés dans le brevet EP-A-0 049 588.

Les électrodes sont généralement à une profondeur de quelques millimètres de la surface supérieure du porte-substrat et ont une épaisseur de quelques centaines de micromètres.

De telles électrodes présentent l'avantage d'éviter de maintenir le substrat par des pièces mécaniques telles que des griffes qui pourraient polluer le substrat ou le soumettre à des influences électriques indésirables, mais ne suppriment pas sous plasma les inconvénients liés à la faiblesse des forces électrostatiques et aux défauts d'homogénéité des forces de pression, qui sont responsables d'un maintien en place peu énergique et de défauts de planéité dans les substrats généralement très minces. Par abus de langage, on entend par planéité du substrat un substrat qui épouse de façon intime la surface du porte-substrat, que celle-ci soit plane ou non (par exemple une surface légèrement convexe suite à un défaut d'usinage). Plus la planéité du substrat par rapport au porte- substrat est bonne, meilleure est la pression de contact et donc l'échange thermique entre substrat et porte-substrat.

D'autres problèmes des porte-substrats électrostatiques connus sont liés à la difficulté d'effectuer des traitements au plasma, surtout au plasma par radiofréquence pour des gravures ioniques réactives : les ondes utilisées sont perturbées par la présence des électrodes.

L'invention a pour objet un porte-substrat électrostatique dans lequel une excellente planéité, donc une bonne facilité d'écoulement de chaleur, est obtenue pendant des réactions sous atmosphère de plasma ainsi qu'un maintien en place ferme, mais dans lequel un maintien en place modéré, afin d'autoriser un décollement aisé après le traitement, s'exerce dans une atmosphère normale avec un contact thermique suffisant. Dans tous les cas, une évacuation satisfaisante de la chaleur engendrée sur le substrat est produite ; sous atmosphère de plasma, cette pression est supérieure à celle qui est obtenue avec les dispositions connues d'électrodes en supposant la différence de potentiel électrique entre les électrodes identiques dans l'invention et dans les dispositifs connus.

On y parvient par une disposition où une des électrodes est filiforme et a une forme correspondant sensiblement au périmètre du substrat ou à une partie seulement du ce périmètre, et entoure au moins partiellement l'autre électrode, qui s'étend sensiblement sous le reste de la surface du substrat avec une surface supérieure.

Le porte-substrat électrostatique selon l'invention est défini par les caractéristiques de la revendication 1.

Il convient de remarquer qu'une disposition à deux électrodes concentriques est également décrite dans le brevet européen cité auparavant. Il est cependant mentionné que les électrodes ont des superficies égales, ce qui n'est pas satisfaisant pour certaines raisons. En effet, si cette disposition garantit une force de serrage assez importante sous et hors plasma par le champ électrique produit entre les électrodes, cette force est uniformément répartie hors plasma et produit donc alors une pression d'appui sur le porte-substrat homogène. Sous plasma, la force de serrage est fortement hétérogène car le substrat est porté au potentiel du plasma quand il est exposé à celui-ci, et ce potentiel n'est normalement pas la moyenne des potentiels des électrodes. Ce serrage hétérogène compromet la planéité du substrat et donc l'échange thermique. Or on constate qu'une pression élevée et homogène est nécessaire pour diminuer la résistance thermique entre le substrat et le porte-substrat.

C'est le cas sous plasma avec l'invention, ce qui permet d'évacuer par le porte-substrat constituant une source froide, de la chaleur rayonnée vers le substrat par le milieu environnant et notamment le plasma. Hors plasma, la pression est par contre hétérogène compte tenu du rapport élevé des surfaces des électrodes mais de ce fait même, la pression électrostatique est très élevée en regard de l'électrode filiforme et suffit à constituer un pont thermique excellent vers le porte-substrat, capable d'évacuer le rayonnement thermique de l'enceinte du réacteur.

Un avantage supplémentaire de l'invention est d'éviter de perturber les ondes de radiofréquences utilisées dans certains traitements au plasma. Pour cela, on réduit avant tout l'épaisseur des électrodes pour la rendre égale à une dizaine de micromètres au maximum et éventuellement la profondeur à laquelle les électrodes sont incluses pour la rendre égale à environ un dixième de millimètre au maximum.

L'invention sera mieux comprise à l'aide des figures suivantes illustrant une réalisation non limitative de l'invention :
- la figure 1 représente une vue de dessus du porte-substrat avec une coupe partielle faisant mieux voir le système d'électrodes ;
- la figure 2 représente une coupe verticale du porte-substrat ;
- les figures 3 à 5 représentent d'autres dispositions d'électrodes possibles, et
- la figure 6 représente un diagramme schématisant l'évolution de la résistance thermique entre le substrat et le porte-substrat en fonction de la pression d'appui ou de contact.

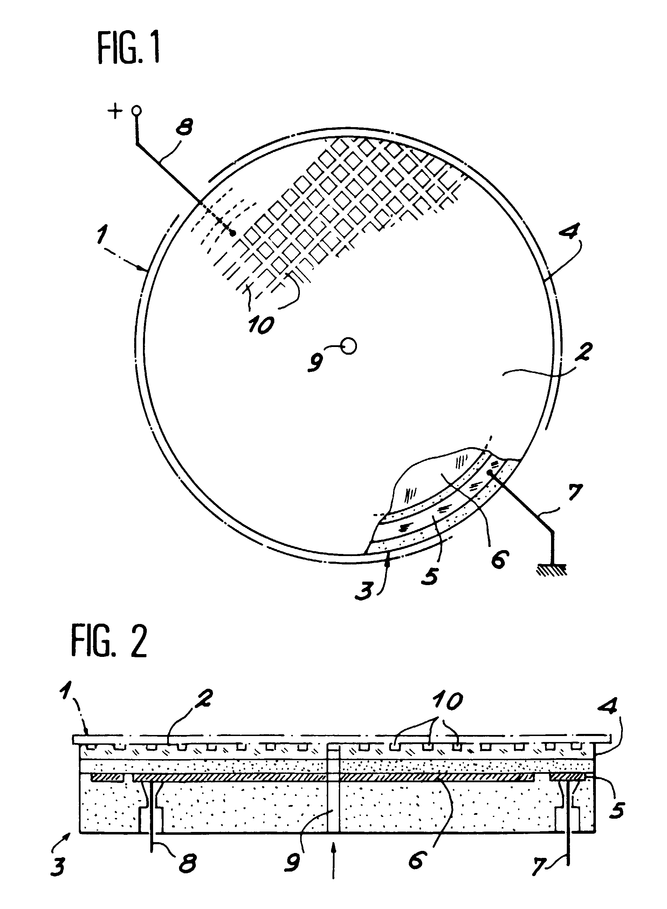

Sur les figures 1 et 2, un substrat 1 en forme de plaquette circulaire est représenté. Un porte-substrat 3 est généralement en matériau isolant et comprend, à sa partie supérieure, une couche de polymère 4 de 5 micromètres d'épaisseur sur la surface supérieure 2, généralement plane, de laquelle repose le substrat 1. Le reste du porte-substrat 3 (semelle) est en un matériau isolant ou une superposition de matériaux isolants (alumine, oxyde de silicium ou nitrure d'aluminium par exemple) ; toutefois, deux électrodes sont incluses dans le porte-substrat 3 entre la couche 4 et la semelle à une profondeur de 25 micromètres environ de la surface supérieure 2 ; ces électrodes sont en un matériau réfractaire (molybdène, tungstène, niobium, silicium dopé...) et ont une épaisseur d'un dixième de micromètre.

La couche 4 peut être constituée d'une couche ou de plusieurs couches, au moins une des couches constituantes étant avantageusement souple et par exemple en polymère.

Comme on le voit mieux sur la figure 1, une des électrodes est une électrode filiforme 5 et s'étend sensiblement sous le périmètre du substrat 1, et l'autre électrode est une électrode pleine 6 entourée par la précédente et dont la surface correspond donc sensiblement à la surface du substrat 1, si on néglige un petit espace nécessaire entre les deux électrodes 5 et 6. Deux lignes électriques 7 et 8 relient respectivement l'électrode filiforme 5 à la terre et l'électrode pleine 6 à un potentiel positif ou négatif. Dans la réalisation représentée, le porte-substrat 3 est percé d'un trou axial 9 qui traverse en particulier l'électrode pleine 6 et la couche supérieure 4 et qui permet d'alimenter un réseau de canaux 10 entrecroisés et creusés sur la surface supérieure 2 en un gaz tel que l'hélium ou l'azote qui y circule en particulier pour favoriser le refroidissement ou le décollement.

Le maintien en place du substrat 1 est réalisé, en préliminaire au traitement sous plasma, par le champ électrique joignant les électrodes 5 et 6. Les forces électrostatiques qui plaquent le substrat 1 sur la surface supérieure 2 ne sont pas homogènes mais sont prépondérantes à la périphérie du substrat 1, au-dessus de l'électrode filiforme 5, ce qui fait qu'une bonne planéité du substrat 1 ne peut être garantie à ce moment, mais compte tenu de la pression électrostatique élevée obtenue sur l'électrode filiforme un contact thermique suffisant est réalisé malgré tout. En revanche, la force totale développée sur le substrat étant relativement faible, elle n'exerce qu'une force modérée de maintien en place du substrat 1, ce qui fait qu'il pourra être facilement décollé après le traitement.

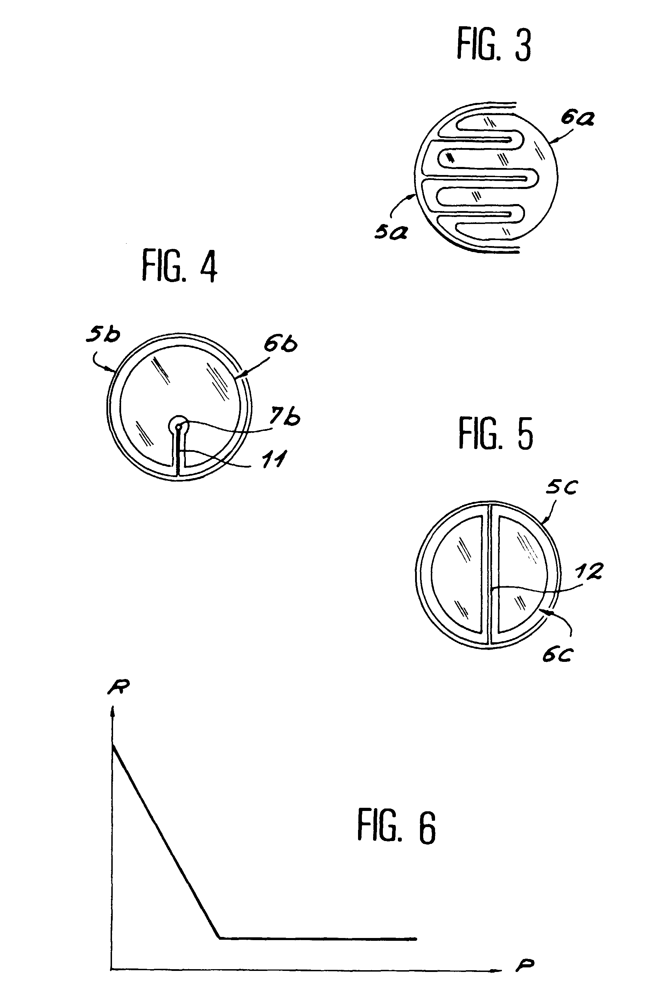

Considérons la figure 6. On voit que la résistance thermique R entre le substrat 1 et le porte-substrat 3 décroît à peu près linéairement selon la pression P de contact entre ces deux éléments, jusqu'à atteindre un minimum pour une pression qui peut être de 500 grammes au centimètre carré, pour des substrats 1 en silicium. Il est donc avantageux d'atteindre cette pression si on veut assurer une bonne évacuation de la chaleur qui peut être rayonnée vers le substrat 1 par le milieu environnant et notamment par le plasma et l'enceinte qui entoure le dispositif. Hors plasma, la puissance à évacuer peut être d'environ dix milliwatts par centimètre carré du substrat 1. Une évacuation satisfaisante est facile à garantir dans l'invention car la pression est proportionnelle au carré de la différence de potentiel entre le substrat 1 et les électrodes 5 et 6 ; comme la surface de l'électrode pleine 6 est de beaucoup la plus importante, le substrat 1 est presque au potentiel de cette électrode pleine 6, et la pression du substrat 1 sur le porte-substrat 3 est très forte au-dessus de l'électrode filiforme 5 et presque nulle ailleurs. La petitesse de la surface sur laquelle la pression maximale est appliquée ne compromet guère l'évacuation de la chaleur car un écoulement thermique par conduction est produit dans le substrat 1 (dans le cas d'électrodes concentriques, cette conduction est centrigure). Si on appelle Po la pression produite par une différence de potentiel Vo et si on applique effectivement la différence de potentiel Vo entre les électrodes, la pression obtenue au-dessus de l'électrode filiforme 5 est égale à 0,85 Po si l'électrode filiforme 5 s'étend sous 8% de la surface S du substrat 1, l'électrode pleine 6 s'étendant sous les 92% restants. La force de maintien est environ 0,07 PoS, la contribution de la zone au-dessus de l'électrode pleine 6 étant à peu près négligeable. La pression serait uniforme sur tout le substrat 1 mais seulement égale à 0,25 Po, et pour une force de maintien de 0,25 PoS, si on utilisait deux électrodes concentriques de superficies égales. Voilà une des raisons de l'intérêt de superficies très différentes. Un rapport d'au moins 5 est conseillé quoique aucune limite précise ne puisse être donnée.

Au cours d'un traitement au plasma conducteur, le substrat 1 est porté au potentiel du plasma. Il forme aussi avec l'électrode pleine 6 un condensateur plan. Les forces électrostatiques de maintien en place sont à la fois importantes et presque uniformes sur tout le substrat 1, ce qui garantit sa planéité et donc un bon contact thermique. Il n'est pas difficile de créer une différence de potentiel entre le plasma et l'électrode pleine 6 suffisante pour obtenir la pression de contact souhaitée (par exemple 500 g/cm² pour du silicium). La chaleur beaucoup plus importante transmise au substrat 1 (de l'ordre de cinq watts par centimètre carré) est donc évacuée rapidement et uniformément par une grande surface d'échange thermique car il n'existe pas de bâillement entre la surface supérieure 2 du porte-substrat 3 et la surface inférieure du substrat 1. Si nécessaire, du gaz circule dans les canaux 10 pour constituer un joint thermique.

La périphérie du substrat 1 qui s'étend au-dessus de l'électrode filiforme 5 n'est pas forcément maintenue en ferme contact mais cet inconvénient est sans importance car cette partie correspond normalement à une zone non utile de surface négligeable.

Des électrodes 5 et 6 minces ne perturbent ni les radiofréquences introduites vers le substrat 1 à travers le porte-substrat 3 ni le plasma. La qualité du traitement est améliorée. De plus, si les électrodes 5 et 6 sont à une profondeur relativement faible sous la surface supérieure 2, la différence de potentiel nécessaire pour réaliser une force de maintien déterminée est diminuée, ce qui renforce l'effet précédent.

L'invention peut bien entendu être mise en oeuvre avec des porte-substrats 3 composés d'autres matériaux et de forme et d'épaisseur différentes. En particulier, les électrodes 5 et 6 ne sont pas forcément circulaires mais ont de préférence une forme adaptée aux substrats qui sont prévus pour les recouvrir.

Le raisonnement a été mené jusqu'ici pour des électrodes 5 et 6 concentriques, mais la rigueur doit être atténuée car des résultats à peu près aussi bons sont obtenus si l'électrode filiforme ne s'étend que sous une partie du périmètre du substrat 1 ou présente des excroissances qui s'étendent sous le centre du substrat 1 et pénètrent dans des indentations que l'autre électrode présente alors. Dans la figure 3, l'électrode filiforme 5a est en forme de peigne formé de filaments parallèles et fins ; dans la figure 4, l'électrode filiforme 5b comporte une jonction filiforme 11 à une ligne électrique 7b qui débouche sous une partie centrale du substrat 1 ; et dans la figure 5 une jonction filiforme 12 diamétrale relie deux points opposés de l'électrode filiforme 5c. Les électrodes centrales 6a, 6b et 6c comportent alors les indentations nécessaires pour ne pas toucher ces excroissances ; la dernière est divisée en deux demi-lunes qui sont évidemment portées au même potentiel électrique par une ligne d'alimentation ramifiée. D'autres réalisations sont encore envisageables. De toute façon, on retrouve les avantages de la réalisation la plus simple si ce n'est que la planéité pendant le traitement sous plasma peut être un peu moins bonne (compte tenu de pertes de surface d'électrodes pleines), mais cet inconvénient est compensé par une forte pression mieux répartie hors du traitement, et par une évacuation de chaleur plus facile.

## Revendications

1. Porte-substrat électrostatique (3) isolant électrique dans lequel sont incluses deux électrodes (5, 6) à des potentiels électriques différents au-dessous d'une surface supérieure (2) du porte- substrat sur laquelle un substrat (1) est posé, où une des électrodes (5) est filiforme, s'étend sensiblement sous au moins une partie du périmètre du substrat (1) et entoure au moins partiellement l'autre électrode (6), qui s'étend sensiblement sous le reste du substrat, caractérisé en ce que l'électrode filiforme a une surface inférieure à celle de l'autre électrode.

2. Porte-substrat suivant la revendication 1, caractérisé en ce que les électrodes (5, 6) ont une épaisseur au plus égale à une dizaine de micromètres.

3. Porte-substrat suivant l'une quelconque des revendications 1 ou 2, caractérisé en ce que les électrodes (5, 6) sont incluses dans le porte-substrat (3) à une profondeur au plus égale à un dixième de millimètre de la surface supérieure (2) du porte-substrat.

4. Porte-substrat suivant l'une quelconque des revendications 1 à 3, caractérisé en ce que la surface supérieure (2) du porte-substrat (3) est striée de canaux (10) d'écoulement d'un gaz.

5. Porte-substrat suivant l'une quelconque des revendications 1 à 4, caractérisé en ce que le porte-substrat (3) comprend une couche supérieure souple (4) à laquelle appartient la surface supérieure (2).

6. Porte-substrat suivant l'une quelconque des revendications 1 à 5, caractérisé en ce que les électrodes ont un rapport de superficies au moins égal à 5.

7. Porte-substrat suivant l'une quelconque des revendications 1 à 6, caractérisé en ce que l'électrode filiforme comporte des excroissances s'étendant sous des portions centrales du substrat et pénétrant dans des indentations de l'autre électrode.

## Patentansprüche

1. Elektrischer isolierender elektrostatischer Substrathalter (3), unter einer oberen Fläche (2) des Substrathalters, auf der ein Substrat (1) angeordnet ist, zwei Elektroden (5, 6) mit unterschiedlichen elektrischen Potentialen enthaltend, wobei eine der Elektroden (5) drahtförmig ist, sich im wesentlichen unter wenigstens einem Teil der Peripherie des Substrats (1) erstreckt und wenigstens teilweise die andere Elektrode (6) umgibt, die sich im wesentlichen unter dem Rest des Substrats erstreckt,
**dadurch gekennzeichnet,**
daß die drahtförmige Elektrode eine kleinere Oberfläche hat als die andere Elektrode.

2. Substrathalter nach Anspruch 1, dadurch gekennzeichnet, daß die Elektroden (5, 6) eine Dicke von höchstens ungefähr 10 mµ haben.

3. Substrathalter nach einem der Ansprüche 1 oder 2, dadurch gekennzeichnet, daß die Elektroden (5, 6) in dem Substrathalter (3) in einer Tiefe mit höchstens gleich einem Zehntel Millimeter Abstand von der oberen Fläche (2) enthalten sind.

4. Substrathalter nach einem der Ansprüche 1 bis 3, dadurch gekennzeichnet, daß die obere Fläche (2) des Substrathalters (3) mit Abzugskanälen (10) eines Gases gerillt ist.

5. Substrathalter nach einem der Ansprüche 1 bis 4, dadurch gekennzeichnet, daß der Substrathalter (3) eine nachgiebige obere Schicht (4) umfaßt, zu der die obere Fläche (2) gehört.

6. Substrathalter nach einem der Ansprüche 1 bis 5, dadurch gekennzeichnet, daß die Elektroden ein Oberflächenverhältnis von wenigstens gleich 5 haben.

7. Substrathalter nach einem der Ansprüche 1 bis 6, dadurch gekennzeichnet, daß die drahtförmige Elektrode Vorsprünge umfaßt, die sich unter den zentralen Teilen des Substrats erstrecken und in Einbuchtungen der anderen Elektrode eindringen.

## Claims

1. Electrically insulating electrostatic substrate holder (3), which contains two electrodes (5, 6) at different electrical potentials below an upper surface (2) of the substrate holder, on which a substrate (1) is placed, in which one of the electrodes (5) is filamentary, extends substantially under at least a part of the perimeter of the substrate (1) and at least partially surrounds the other electrode (6), which extends substantially under the rest of the substrate, characterized in that the filamentary electrode has a smaller surface area than the other electrode.

2. Substrate holder according to Claim 1, characterized in that the electrodes (5, 6) have a thickness at most equal to approximately 10 micrometres.

3. Substrate holder according to any one of Claims 1 and 2, characterized in that the electrodes (5, 6) are contained in the substrate holder (3) at a depth at most equal to one-tenth of a millimetre from the upper surface (2) of the substrate holder.

4. Substrate holder according to any one of Claims 1 to 3, characterized in that the upper surface (2) of the substrate holder (3) is striated with flow channels (10) for a gas.

5. Substrate holder according to any one of Claims 1 to 4, characterized in that the substrate holder (3) comprises a flexible upper layer (4) to which the upper surface (2) belongs.

6. Substrate holder according to any one of Claims 1 to 5, characterized in that the electrodes have a surface-area ratio at least equal to 5.

7. Substrate holder according to any one of Claims 1 to 6, characterized in that the filamentary electrode has protuberances extending under the central portions of the substrate and extending into indentations in the other electrode.
